# EUROPEAN PATENT SPECIFICATION

(11) **EP 0 966 763 B1**
(45) Date of publication and mention of the grant of the patent: **12.01.2005**
(21) Application number: 98904992.9
(22) Date of filing: 06.02.1998
(51) Int. Cl.: H01L 29/78, H01L 29/739, H01L 29/24

(54) **STRUCTURE FOR INCREASING THE MAXIMUM VOLTAGE OF SILICON CARBIDE POWER TRANSISTORS**
STRUKTUR ZUR ERHÖHUNG DER MAXIMALEN SPANNUNG VON SILIZIUMKARBID-LEISTUNGSTRANSISTOREN
STRUCTURE POUR AUGMENTER LA TENSION MAXIMALE DE TRANSISTORS DE PUISSANCE AU CARBURE DE SILICIUM

(30) Priority: 07.02.1997 US 797535; 07.02.1997 US 795135
(43) Date of publication of application: 29.12.1999
(73) Proprietor: Cooper, James, Albert, Jr., West Lafayette, IN 47906 (US); Tan, Jian, West Lafayette, IN 27906 (US)
(72) Inventor: Cooper, James, Albert, Jr., West Lafayette, IN 47906 (US); Tan, Jian, West Lafayette, IN 27906 (US)
(74) Representative: Warren, Anthony Robert
(86) International application number: PCT/US1998/002384
(87) International publication number: WO 1998/035390

(56) References cited:
- EP-A- 0 345 380
- WO-A-94/13017
- US-A- 4 941 026
- US-A- 5 168 331
- US-A- 5 233 215
- US-A- 5 488 236
- CONSTAPEL R ET AL: "TRENCH-IGBTS WITH INTEGRATED DIVERTER STRUCTURES" PROCEEDINGS OF THE 7TH. INTERNATIONAL SYMPOSIUM ON POWER SEMICONDUCTOR DEVICES AND IC'S. (ISPSD), YOKOHAMA, MAY 23 - 25, 1995, no. SYMP. 7, 23 May 1995, INSTITUTE OF ELECTRICAL AND ELECTRONICS ENGINEERS, pages 201-206, XP000594258
- RAMUNGUL N: "Design and simulation of 6H-SiC UMOS FET and IGBT for high-temperature power electronics applications" INST. PHYS. CONF. SER., NO. 142: CHAPTER 4, PROCEEDINGS OF INTERNATIONAL CONFERENCE ON SILICON CARBIDE AND RELATED MATERIALS, 18 - 21 September 1995, KYOTO, JAPAN, pages 773-776, XP002063000
- BALIGA B J: "TRENDS IN POWER SEMICONDUCTOR DEVICES" IEEE TRANSACTIONS ON ELECTRON DEVICES, vol. 43, no. 10, October 1996, pages 1717-1731, XP000626907
- JAYANT BALIGA B: "CRITICAL NATURE OF OXIDE/INTERFACE QUALITY FOR SIC POWER DEVICES" MICROELECTRONIC ENGINEERING, vol. 28, no. 1/04, 1 June 1995, pages 177-184, XP000513457

## Description

### Field of the Invention

The present invention relates to insulated gate power semiconductor devices and in particular relates to UMOS and IGBT field effect transistors formed in silicon carbide.

### Background of the Invention

The present invention relates to power semiconductor devices and particularly power MOSFETs (metal-oxide semiconductor field-effect transistors) formed in silicon carbide. A power MOSFET is a small, reliable, electronically controllable switching device that has growing application in high voltage/high power devices and integrated circuits. Power MOSFETs have a variety of applications in numerous fields including communications, consumer applications, data processing, military, industrial, automotive and related markets. In particular, power MOSFETs have inherently higher switching speeds than bipolar transistors and are accordingly particularly useful in high frequency applications. Although silicon has been the material of choice for many semiconductor applications, its fundamental electronic structure and characteristics prevent its utilization beyond certain parameters. Thus, interest for power MOSFET devices has turned from silicon to other materials, including silicon carbide. Silicon carbide has a number of intrinsic advantages for power MOSFET applications. Silicon carbide has a high field saturation velocity which is three times larger than that of gallium arsenide (GaAs). Silicon carbide has a high intrinsic breakdown field ten times higher than gallium arsenide and a thermal conductivity ten times as high as gallium arsenide.

SiC is unique among compound semiconductors in that its native oxide is SiO, the same oxide as silicon. This means that the workhorse power devices used in silicon, *i.e.,* the power MOSFET, insulated gate bipolar transistor (IGBT), and MOS-controlled thyristor (MCT) can all be fabricated in SiC.

Because of technological differences, however, power devices in SiC can be very different from silicon devices, and a direct translation of silicon concepts to SiC is not always possible. SiC has a breakdown field eight times higher than silicon, and SiC power devices can have specific on resistances 100 to 200 times lower than similar devices in silicon. Nevertheless, several practical problems must be addressed before such devices can be realized. Bipolar devices in SiC (e.g., the IGBT and MCT) suffer from short minority carrier lifetimes, which are typically in the range of 40 to 400 nanoseconds (ns). As a result, the highest current gains yet reported in SiC bipolar transistors are in the range of 10 to 12. Because the peak electric field can be eight times (8X) higher than in silicon, SiC switching devices can be fabricated with a drift region about 8X thinner than comparable silicon devices. If the drift region is 8X thinner, the doping of the drift region can be about twelve times (12X) higher. The resistance of the drift region is proportional to the thickness and inversely proportional to the doping, so the specific on-resistance of a SiC device can be from 100-200 times smaller than a comparable silicon device of equal voltage rating. This means the SiC device can be 100-200 times smaller than the comparable silicon device. Alternatively, if the SiC device has the same area as the comparable silicon device, its specific on-resistance will be 100-200 times lower.

Although it offers substantial advantages over silicon, SiC is still relatively immature as a semiconductor material. Single crystal wafers of SiC have only been commercially available since 1991, and a number of technical problems need to be addressed before SiC can supplant silicon in power device applications. The main problems are related to crystal growth of SiC materials. Because of the very high melting point, single crystal boules cannot be pulled from a melt as in the Czochralski method used for silicon. Instead, the boule is grown on a seed crystal by a high temperature sublimation process. At present, the boules grown by the sublimation process are about 2 inches in diameter, much smaller than the 6 to 8 inches common in the silicon industry. In addition, the material still has a relatively large number of defects. These defects include micropipes; *i.e.*, micron size holes which run completely through the wafer. Fortunately, the micropipe problem appears to be under control, with micropipe densities as low as 27 cm⁻² in the most recent wafers, and at the current rate of improvement micropipes should eventually be completely eliminated.

SiC crystallizes in the hexagonal lattice with alternating planes of silicon and carbon atoms. The Si-C plane-pairs can occur in three orientations, labeled A, B, and C. The particular stacking sequence of Si-C plane-pairs identifies the polytype of the crystal. SiC occurs in a variety of polytypes, but the most common are 3C, 4H, and 6H. At the present time, the 6H polytype is the most thoroughly characterized, but the 4H polytype is more attractive for power devices because of its higher electron mobility.

Although it has a much higher breakdown field than silicon, SiC has lower hole and electron mobilities and shorter minority carrier lifetimes. The shorter lifetimes allow bipolar devices in SiC to switch much faster than comparable silicon devices, but they limit the current gain of SiC bipolar transistors to very low values, typically less than 20. For high-speed switching with low forward voltage drop, the best SiC device will be a power MOSFET. The typical power MOSFET in silicon is a DMOS (or doubly diffused MOS) structure. The short channel length is achieved by diffusing the p-type base layer and the n+ source through the same oxide window, thus removing any dependence on alignment of photomasks. The p-type base must have a sufficient number of dopant atoms per unit area (thickness times concentration) to prevent punch-through by the drain electric field in the blocking state. Unfortunately, the DMOS concept is difficult to translate to SiC because it is not feasible to thermally diffuse dopant atoms in SiC. One might artificially construct a similar structure using ion implantation, but the channel length would then be defined by a mask alignment, and it would be difficult to implant the p-type impurity to sufficient depth to prevent punch-through. For these reasons, a vertical UMOSFET structure-*i.e.*, a combination of SiC epitaxial layers and a trench is the most practical in SiC.

The theoretical potential for SiC MOSFETs has not been reached, however, because the maximum voltage in silicon carbide MOSFETs is instead limited by the breakdown field of the silicon dioxide (SiO₂) insulator. Although this oxide does not actually fail until fields of about 10⁷ Volts per centimetre (V/cm) are reached, from a practical standpoint the low-term reliability of the oxide degrades severely under fields above about 2-3 X 10⁶ V/cm. Such a field limitation is already slightly lower than the breakdown field of silicon carbide. Even more problematic, however, because of the 2.5:1 ratio of the dielectric constants of silicon dioxide and silicon carbide, Gauss' law requires that the maximum field in the silicon carbide power transistors are in practical terms limited to a blocking voltage much lower than that of which silicon carbide is theoretically capable.

Accordingly, the need exists for power transistors, particularly power MOSFETs, in silicon carbide that are capable of taking greater advantage of silicon carbide's favorable intrinsic properties, and it is an object of the invention to provide such transistors.

US 5 488 236 A discloses a gate-controlled bipolar transistor including a buried collector region.

### Summary of the Invention

Accordingly, the present invention consists in a UMOS power transistor as defined in claim 1.

The invention also consists in an insulated gate bipolar power transistor (IGBT) as defined in claim 10.

### Brief Description of the Drawings

Figure 1 is a cross-sectional schematic diagram of a UMOS according to the prior art accompanied by informal plots of the field along the p-n and MOS sections of such prior art devices;
Figure 2 is a similar schematic cross-sectional view of a UMOS helpful for understanding the present invention and again accompanied by informal plots of the resulting field along the p-n and MOS sections of the device;
Figure 3 is a user-defined grid of a conventional prior art UMOS using device simulation software;
Figure 4 is a grid similar to Figure 3, but expanded in the vertical direction;
Figures 5 and 6 are plots of the electric field strength at various positions within a conventional prior art UMOS based on the grids of Figures 3 and 4;
Figures 7 and 8 are user-defined grids for the UMOS of the present invention based on a 4 micron and a 16 micron vertical cross-section, respectively;
Figures 9 and 10 are plots of the electric field strength at various positions within the UMOS of the present invention as defined in Figures 7 and 8;
Figures 11 and 12 plot the same type of information as Figures 9 and 10, but at a higher applied voltage;
Figure 13 is a plot under the same conditions as Figures 11 and 12, but along a different portion of the device;
Figures 14 and 15 are plots similar to Figures 9-12, but taken at a lower doping level than the devices modeled in the previous figures;
Figures 16-18 are similar plots for the lower doping levels of Figures 14 and 15, but under much higher applied drain voltages;
Figure 19 is an IGBT according to the present invention;
Figure 20 is a cross-sectional view of a UMOS according to the present invention; and
Figure 21 is a cross-sectional view of an IGBT according to the present invention.

### Detailed Description of the Preferred Embodiments

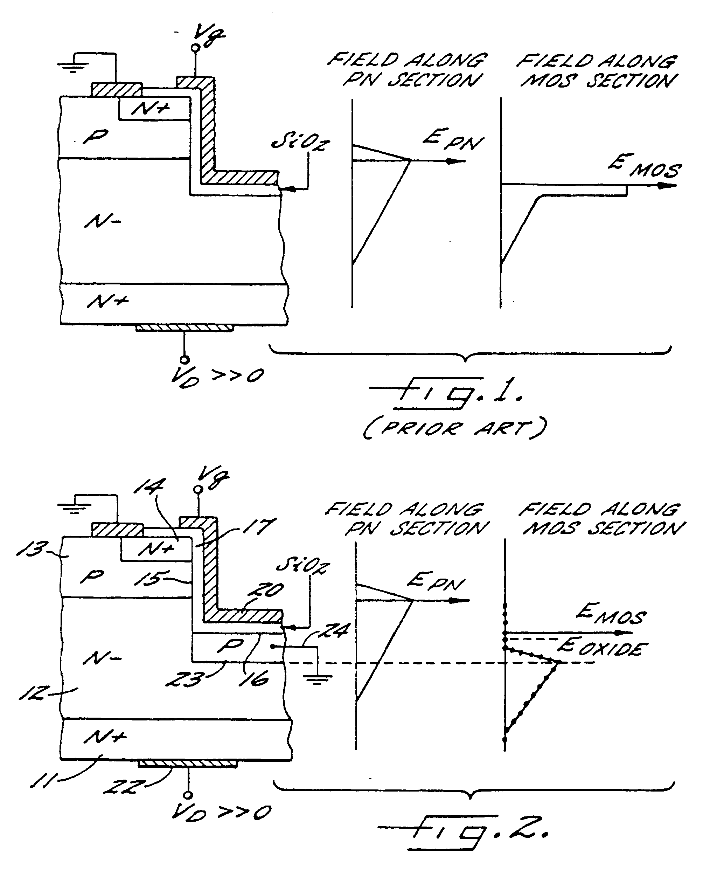

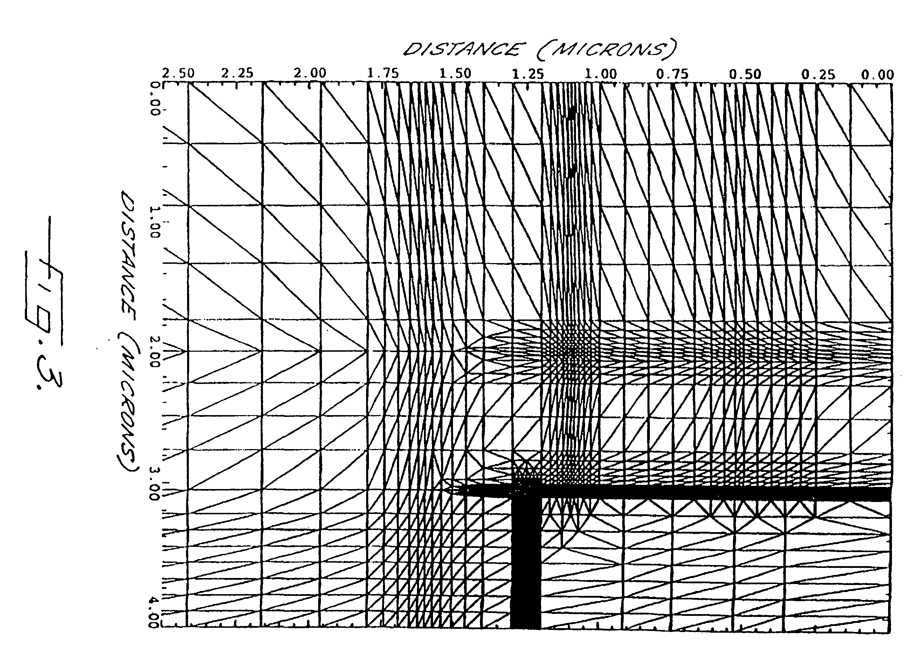

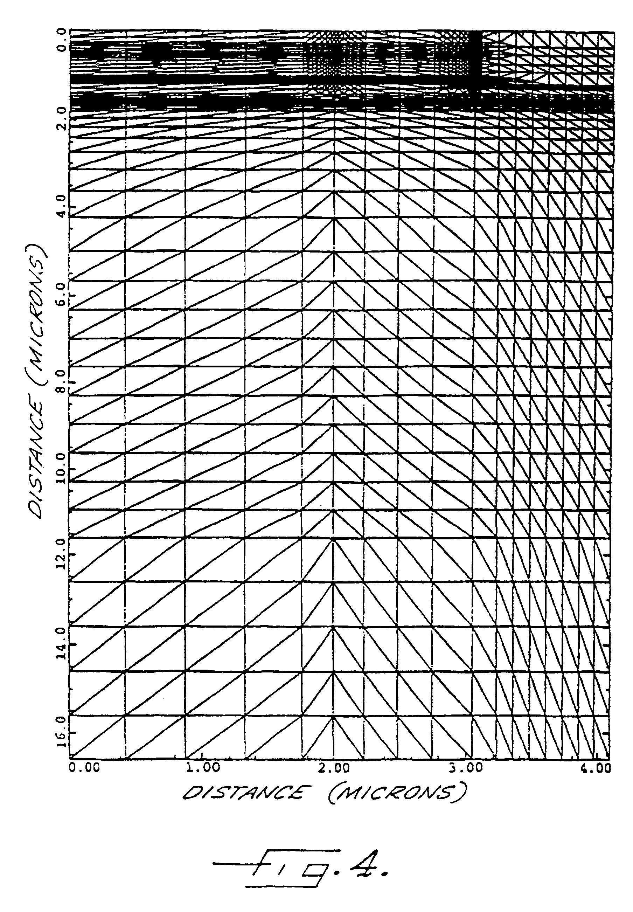

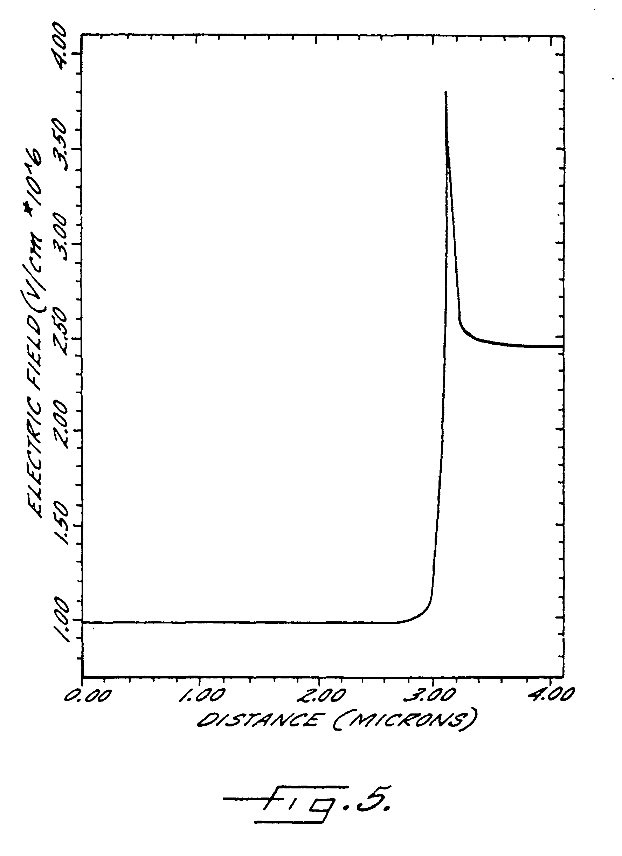

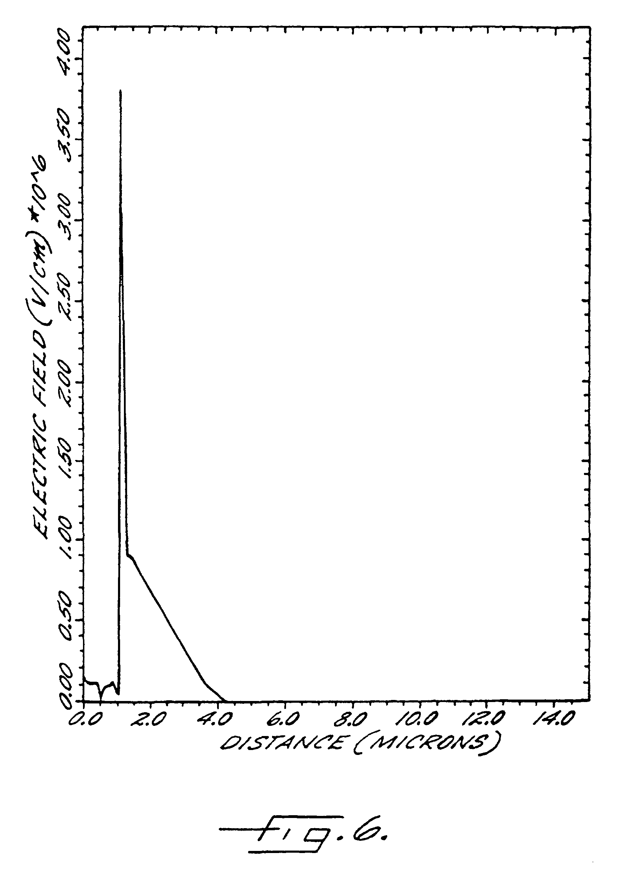

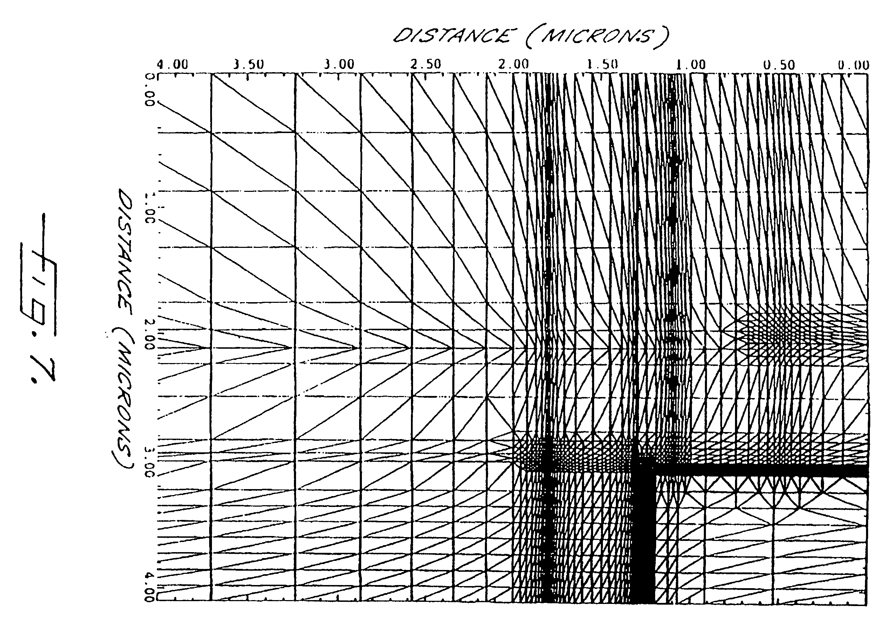

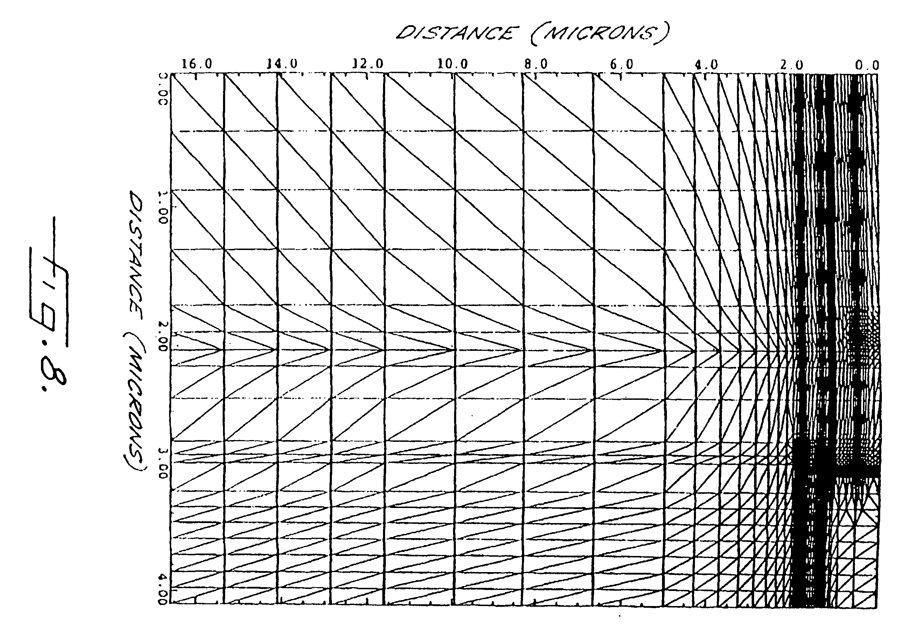

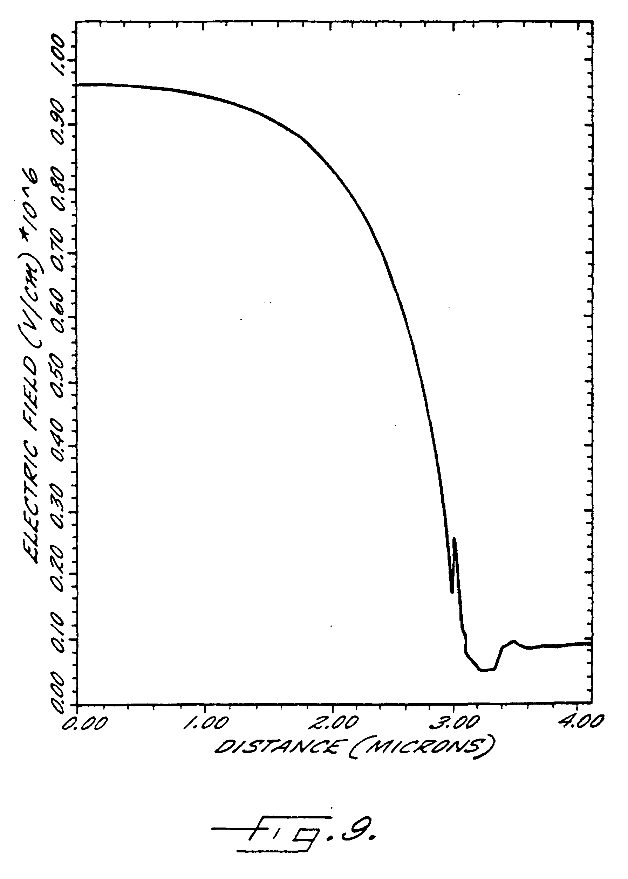

In its broadest sense, the preferred embodiments of the invention are an insulated gate transistor, field-effect or bipolar, in which the gate material is an oxide, and in which the opposite conductivity semiconductor is placed adjacent the oxide to protect the oxide from high electric fields. An example helpful for understanding the invention is a silicon carbide UMOS power transistor broadly designated at 10 in Figure 2. For comparison purposes, a prior art device is illustrated in Figure 1.

The UMOS 10 is formed of an n-type single-crystal silicon carbide substrate 11, an n-type silicon carbide epitaxial layer 12 on the n-type substrate 11 and a p-type epitaxial layer 13 on the n-type epitaxial layer 12. An n-type well 14 is formed in the p-type epitaxial layer 13. A gate trench defined by the trench wall 15 and a flat trench bottom 16 extends through the n-type well 14 and the p-type epitaxial layer 13 and terminates in the n-type epitaxial layer 12. A gate oxide 17 covers the wall 15 and bottom 16 of the trench. Respective ohmic contacts define the source, gate, and drain. In particular, the gate contact 20 is on the oxide layer 17, the source contact 21 is on the p-type epitaxial layer 13 and overlaps with the n-type well 14, and the drain contact 22 is made to the n-type substrate 11 so that the three contacts define the source, gate, and drain of the UMOS 10.

There are a number of metals and composite metal systems that are appropriate for these contacts and, as these are generally well understood in the art, they will not be described in detail herein other than to note that, for example, nickel or nickel-titanium combinations are appropriate ohmic contacts to n-type silicon carbide while aluminum or aluminum-titanium combinations are useful ohmic contacts to p-type silicon carbide. More recently cobalt silicide (CoSi₂) has shown promise as an ohmic contact material to p-type silicon carbide.

As noted in the background portion, within the last decade, silicon carbide substrates, and substrates that include appropriate epitaxial layers, have become commercially available. Thus, their formation and growth will not be discussed in detail herein, other than to note that exemplary substrate and epitaxial growth techniques are set forth in U.S. Patents Nos. 4,912,063; 4,912,064; Re. 34,861; and 5,011,549. Similarly, the oxide layer 17 can be a deposited or a thermal oxide, and some advantageous methods of forming high-quality silicon dioxide layers on silicon carbide are set forth in U.S. Patent No. 5,459,107. Appropriate ohmic contact structures are set forth for example in U.S. Patents Nos. 5,323,022 and 5,409,859.

As Figure 2 indicates, in the example, the n-type substrate 11 is somewhat more heavily doped than the n-type epitaxial layer 12 with appropriate doping concentrations being for example 2 x 10¹⁹ cm⁻³ for the substrate 11 and 2 X 10¹⁶ cm⁻³ for the n- epitaxial layer 12. It will be understood that the use of an n-epilayer on an n+ substrate offers certain advantages for current flow in particular situations. In other embodiments, a single n-type layer or substrate provides an appropriate drain structure. Similarly, the n-type well 14 is more heavily doped, comparatively speaking, than either the p-type epitaxial layer 13 or the n-type epitaxial layer 12. An exemplary doping level for the n-type well 14 is also 2 X 10¹⁹ cm⁻³, and for the p-type layer 13 is 5 X 10¹⁷ cm⁻³. The example further comprises a grounded p-type protective region 23 between the oxide layer 17 and the n-type epitaxial layer 12, and which, in the embodiment illustrated in Figure 2, is under the bottom portion of the trench oxide layer 17. The p-type protective region 23 is grounded by the ohmic contact shown schematically at 24 in Figure 2. This ohmic contact is typically formed on the horizontal surface 16 at a location not covered by the gate metal and gate oxide, for example, at a point on a plane behind the view of Figure 2. The p-type region 23 is aligned with the bottom 16 of the gate trench for protecting the oxide 17 in the trench from the degrading or breakdown effects of a large positive voltage applied to the drain contact 22.

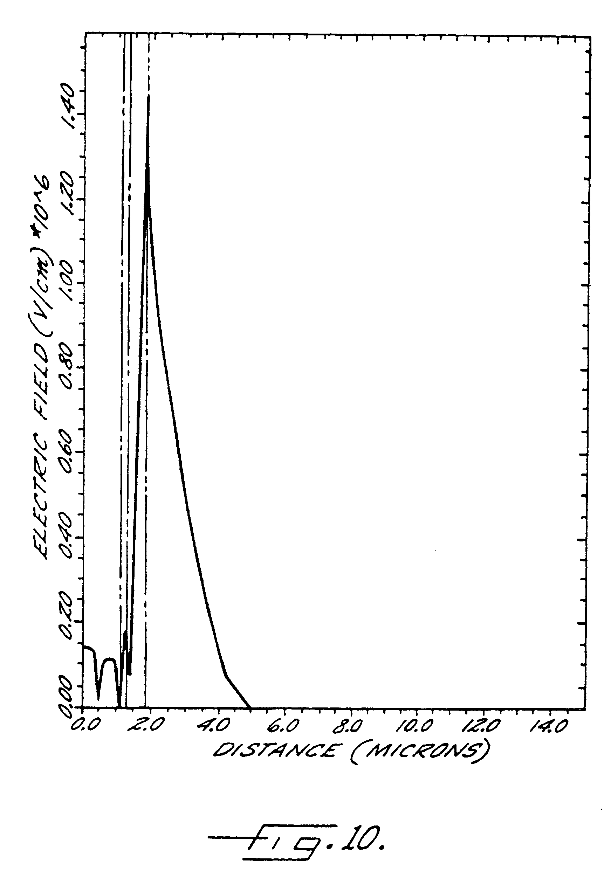

Stated independently of specific polarity, the opposite type protective region (23 in Figure 2) is adjacent the insulated gate (silicon dioxide 20 in Figure 2) and protects the gate insulator material 20 from the degrading or breakdown effects of a large voltage applied to the drain. The results of this structure are informally illustrated by comparing the field strength plots of Figure 1 with those of Figure 2, and are more formally illustrated by the information presented in Figures 3-18. In both Figure 1 and Figure 2, the field strength along the p-n section is basically the same. The effect of adding the p-layer 23 of the present invention, however, is illustrated by the difference between the field along the MOS section plotted in Figure 1 versus that plotted in Figure 2. As Figure 2 illustrates, the invention keeps the peak field strength away from the oxide so that a high voltage applied to the drain (as indicated by V_{d}>>0 in Figure 2), does not affect the oxide layer 17 in the UMOS 10 of Figure 2 in the same way that a similarly high drain voltage affects the oxide layer in the prior art example of Figure 1.

By essentially protecting the oxide layer 17 from the field created by the high voltage, the p-type layer 23 permits the performance of the silicon carbide device to more closely approach its theoretical potential.

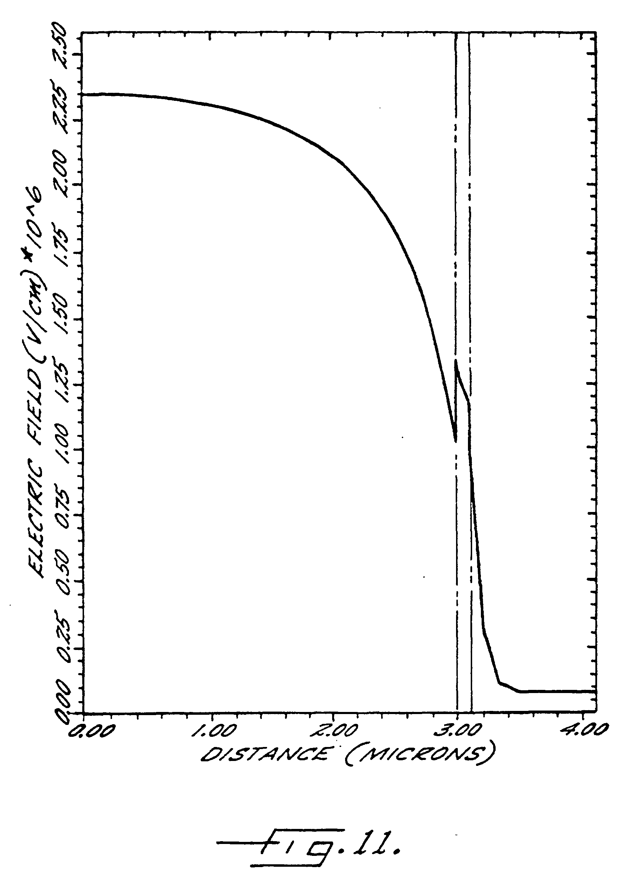

In order to obtain a more formal indication of the performance of the device, the design illustrated in Figure 2 was analyzed using the MEDICI™ device simulation program. MEDICI™, which is one of a number of commercially available device-simulation programs, was used to find the e-field value of each point inside the different SiC UMOS devices with the different biases. From this the maximum bias for each UMOS could be determined with the maximum e-field in the oxide layer lower than or equal to 3 X 10⁶ V/cm. For analytical purposes, this was defined as the maximum bias voltage for the device. The MEDICI™ program is available from TMA, 595 Lawrence Expressway, Sunnydale, CA 94087 (URL: http://www.tmai.com). MEDICI™ predicts the electrical characteristics of arbitrary two-dimensional structures under user-specified operating conditions. The analysis of MOSFETs is one of the typical device applications for which the MEDICI™ simulation program is useful. The MEDICI™ results are illustrated in Figures 3-18. Figures 3-6 describe a conventional prior art UMOS, while Figures 7-18 describe a UMOS according to the present invention. Figure 3 is a user-defined grid for a conventional UMOS power device such as the one illustrated in Figure 1. Using the MEDICI™ program, the number and location of the grid points were selected to define the desired device in a two-dimensional pattern. Typically, and as Figure 3 illustrates, a larger number of grid points are selected and assigned to those portions of the device that will demonstrate the greatest effects or responses to voltage, current, and electric field. For example, in Figure 3, a large number of grid points are assigned to the oxide and appear as the dark L-shaped wide lines. As the listed dimensions indicate, Figure 3 illustrates a cross-sectional portion of a conventional UMOS that is approximately 4 microns wide and 2 microns high. Figure 4 is based upon the identical data as Figure 3 except that Figure 4 is expressed along a vertical distance of approximately 16 microns.

Figure 5 demonstrates the behavior of a conventional SiC UMOS as modeled by the MEDICI™ program. The plot of Figure 5 is taken along the line y = 1.2033 microns; *i.e.,* a horizontal line between the left- and right-hand borders of Figure 3. As Figure 3 illustrates, such a horizontal line passes through the oxide portion at the bottom of the UMOS trench. In particular, Figure 5 models the behavior of the conventional UMOS at a drain voltage of 150 volts. Under such conditions, the peak electric field is approximately 3.82 X 10 10⁶ V/cm and occurs along the horizontal line at an x coordinate of about 3.08 microns. Again returning to Figure 3, this corresponds to the comer of the oxide, which is generally the expected position for the highest field strength. As noted above, such a high field strength can cause the oxide to either breakdown immediately, or to degrade so rapidly as to render the device generally useless under such conditions. As also noted earlier, in order to avoid oxide degradation, the peak electric field in the oxide should desirably be kept below about 2.5-3 x 10⁶ V/cm, and preferably even lower.

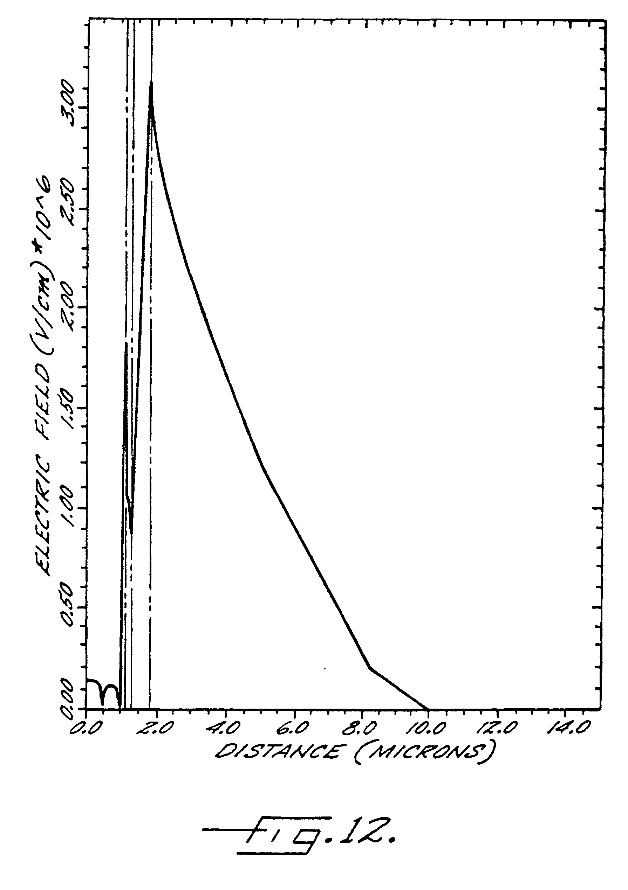

Figure 6 illustrates the same information as Figure 5, but does so by measuring the field along a vertical line defined by an x coordinate of 3.0967 microns, and again with an applied drain voltage of 150 volts. As Figure 6 demonstrates, the peak value of the electric field is again about 3.82 X 10⁶ V/cm and occurs at the comer of the oxide; *i.e.*, a coordinate defined by x = 3.1 microns and y = 1.25 microns.

Figure 7 is the user-defined MEDICI™ grid for the UMOS with the implanted p-layer (e.g., illustrated at 23 in Figure 2) having a depth of about 0.5 microns. In a manner similar to Figure 3, the largest number of points in the grid are selected within the oxide portion, which again appears as the large L-shaped solid lines in Figure 7. Figure 7 also includes, however, a large number of grid points corresponding to the implanted p-layer just below the oxide. As with Figure 3, the cross-sectional grid of Figure 7 covers approximately 4 microns vertically and 4 microns horizontally.

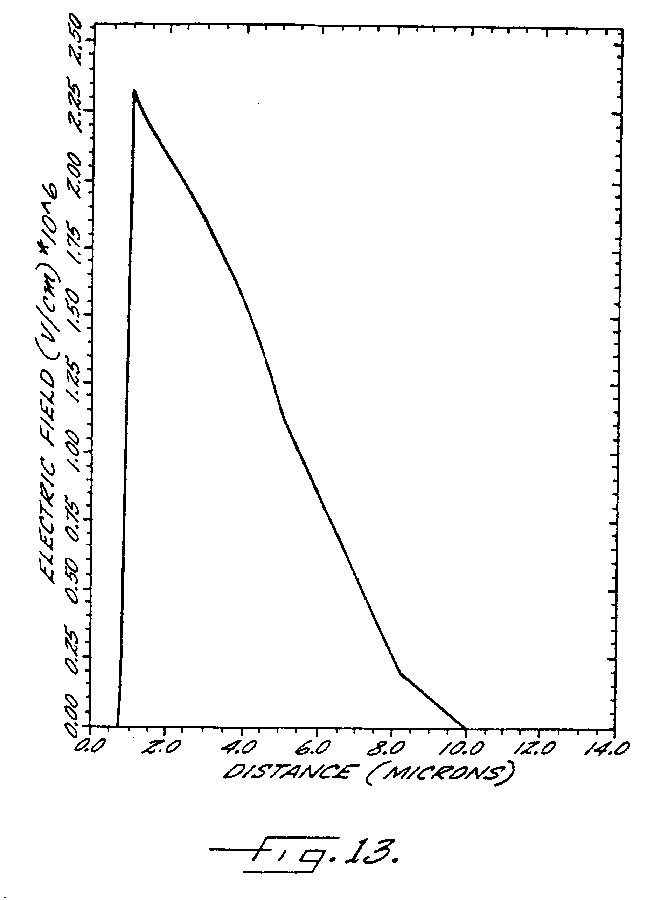

Figure 8 corresponds to the same structure as does Figure 7, but is plotted to show a depth of 16 microns.

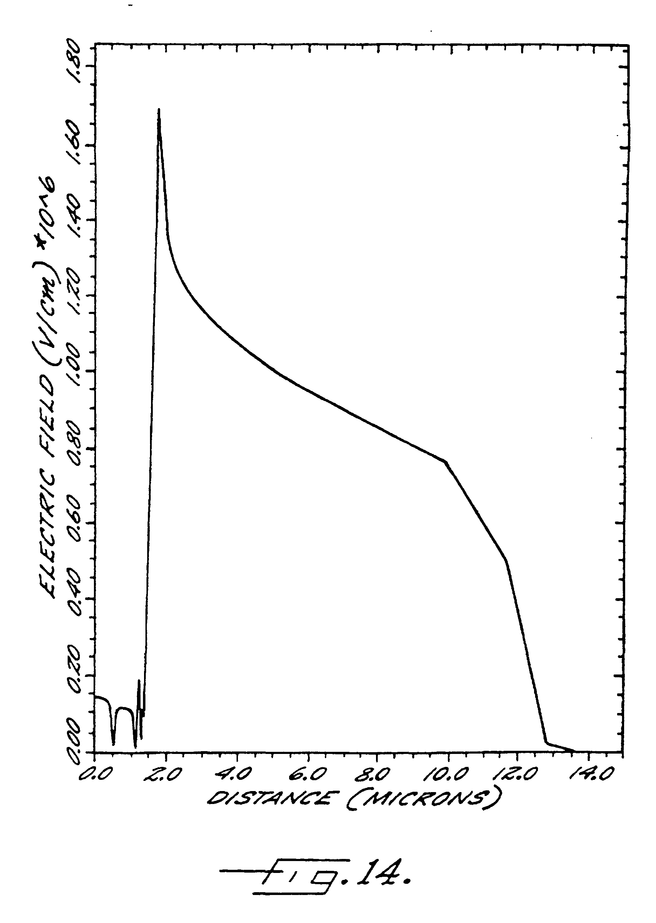

Figure 9 shows the behavior predicted by the MEDICI™ program for the UMOS under an applied drain voltage of 150 volts, and doping concentrations of 2.0 X 10¹⁶ cm⁻³ (2E16) in the n-layer (e.g., 12 in Figure 7), 2 x 10¹⁹ cm⁻³ in the substrate 11, and 5 X 10¹⁷ cm⁻³ in both the p-type epilayer 13 and in the grounded p-type region 23. Figure 9 is taken along a horizontal line again defined by y = 1.2023 microns; *i.e.,* the same horizontal line as Figure 5. Thus, Figures 5 and 9 provide a basis for comparison of the two devices at a structurally equivalent point. As Figure 9 demonstrates, a peak in the electric field still occurs at the comer of the oxide (x = 3 microns, y = 20 1.2 microns), but also demonstrates that the electric field at that point has been greatly reduced; *i.e.*, about 0.278 X 10⁶ V/cm; *i.e.,* more than an order of magnitude lower than the electric field at the oxide comer without the implanted p-layer (as compared to the field of 3.82 X 10⁶ V/cm at the same point in Figures 5 and 6).

Figure 10 plots the same information as Figure 9, but again taken along the vertical line at x = 3.0967. Thus, Figure 10 corresponds in its geometry to Figure 6. Figure 10 shows two peaks. The largest of the two peaks falls at the coordinates x = 3.1 and y = 1.75 which, referring to Figure 7, is adjacent the p-n junction. Figure 10 also shows that the oxide peak falls at the corner of the oxide (x = 3.1 and y = 1.2), but is again greatly reduced from the prior art device; *i.e.,* about 0.18 x 10⁶V/cm.

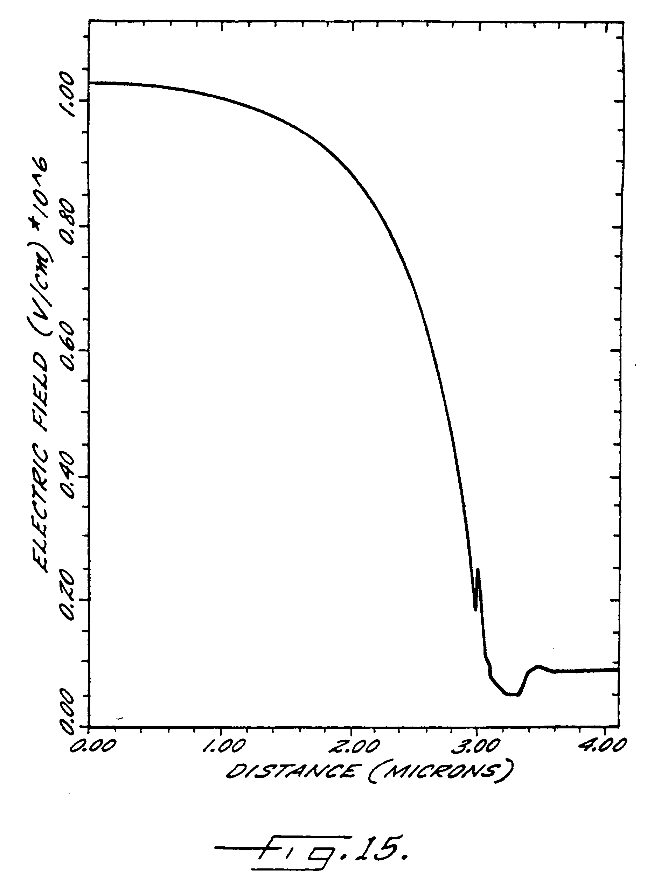

Figure 11 plots the electric field along the same horizontal line (y = 1.2033 microns) as in the other similar figures, but at an applied drain voltage of 950 volts in the structure of the invention. Figure 11 also represents the same doping level (2E16) in the n-layer as in Figures 9 and 10. Once again the peak electric field is at the comer of the oxide (x = 3, y = 1.2 microns) but is still relatively low; *i.e.*, about 1.32 x 106 V/cm. Stated differently, even under an applied drain voltage of 950 volts, the structure of the present invention reduces the electric field at the comer of the oxide to a fraction of the electric field at the same position under far less voltage in conventional structures.

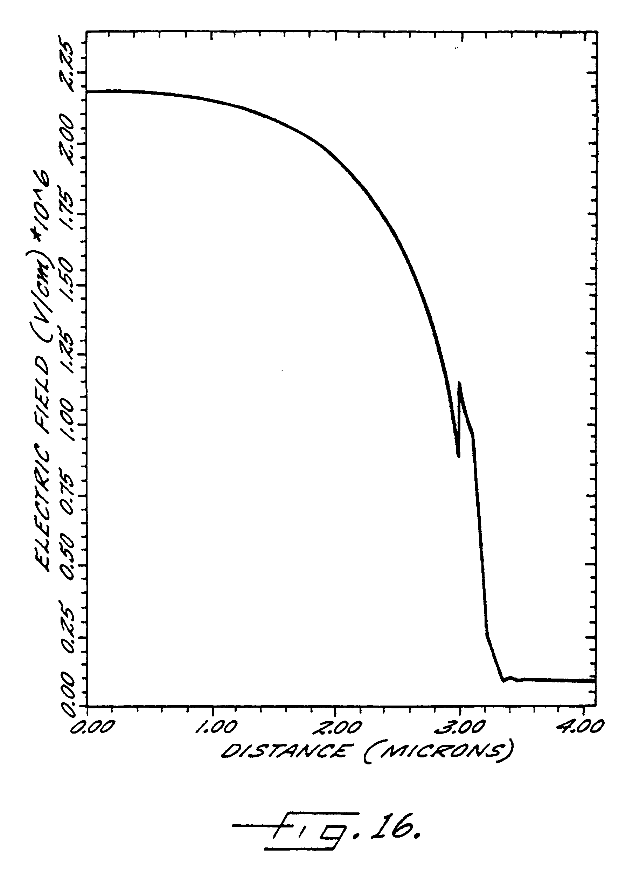

Figure 12 corresponds to Figure 11 in that it represents an applied drain voltage of 950 volts, but as in other similar plots, is taken along the vertical line x = 3.0967 microns. Figure 12 also includes two peaks. Again, the higher of the two peaks (at coordinates x = 3.1 and y = 1.9 microns) represents the field at the p-n junction and, at a strength of approximately 3.12 X 10⁶ V/cm is approaching the breakdown field of silicon carbide at this doping level. The other peak again occurs at the comer of the oxide (x = 3.1 microns, y = 1.2 microns) and is about 1.82 x 10⁶ V/cm, well within the desired field strength parameters. Figure 13 is taken along a slightly different vertical line (x = 1.0536 microns) than the previous plots, but also represents 950 V applied to the drain and an n-doping level of 2E16. This particular x coordinate represents a vertical slice of the structure of the invention that is somewhat removed from the oxide, and thus demonstrates the field strength through the p and n portions of the transistor and particularly the field at the p-n junction (x = 1.0536, y = about 1.1 microns).

Figure 13 shows the peak field strength in the silicon carbide near the p-n junction to be on the order of about 2.33 x 10⁶ V/cm, which is again within the desired limits. As noted above, Figures 5 through 13 were all calculated at doping concentrations in the n-layer of 2E16 cm⁻³. Because of the effect of doping on breakdown voltage, the MEDICI™ program was again used to simulate the behavior of the structure of the invention at a reduced doping level of 2.S X 10¹⁵ cm⁻³ (2.5E15) in the n- layer. The grid is the same as that originally defined in Figures 7 and 8, and thus the coordinates of Figures 14-18 correspond to those in Figures 9-13.

Figure 14 is another plot of the electric field taken along the vertical line at coordinate x = 3.0967 microns, with an applied drain voltage of 950 volts at the lower doping level of 2.5E15 cm⁻³. Figure 14 includes two peaks that again respectively represent field strength at the oxide and the p-n junction. The field strength at the p-n junction (x = 3.1 and y = 1.95 microns) is about 1.69 X10⁶ V/cm well within the desired limits. Similarly, the maximum field in the oxide (x = 3.1 and y = 1.25 microns) is about 0.19 X 10⁶ V/cm well under the maximum field of the corresponding prior art devices.

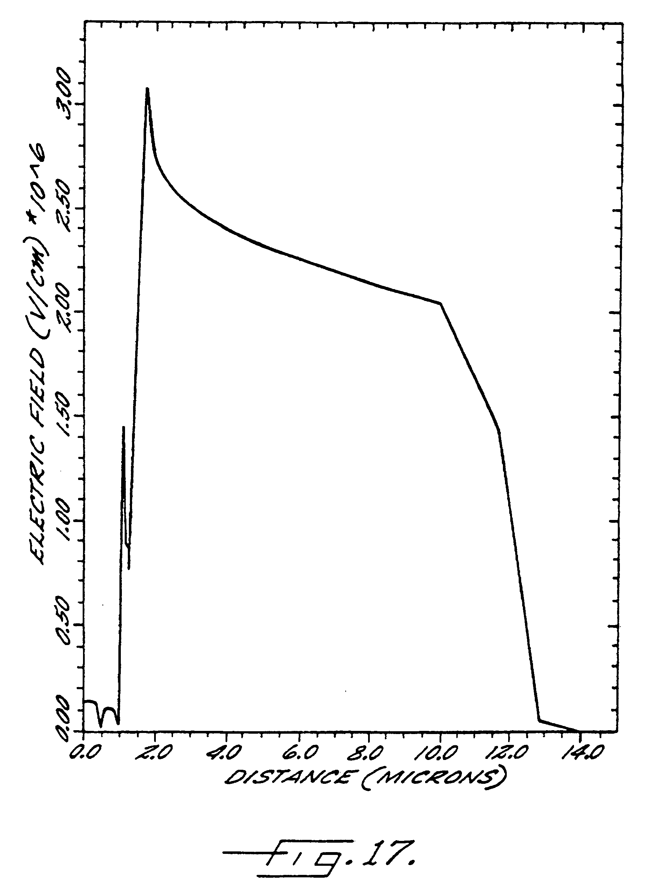

Figure 15 corresponds to Figure 14, but with the data plotted along the horizontal line y = 1.2033 microns. Taken along this line, the peak field strength again occurs at the corner of the oxide (x = 3 and y = 1.2 microns) with a value of approximately 0.25 X 10⁶ V/cm once again well under the maximum field of the prior art devices.

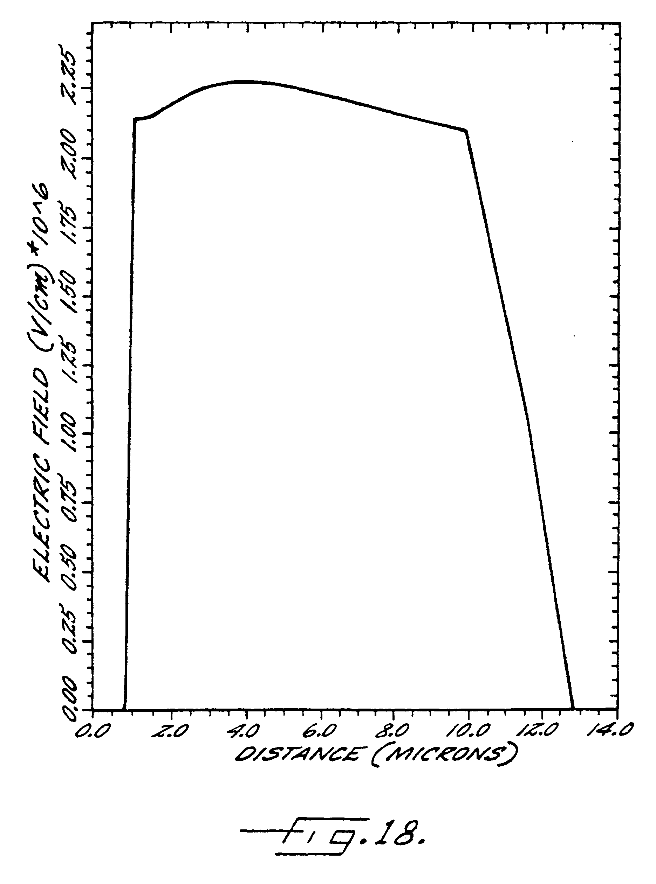

Figures 16 and 17 represent plots for the same doping levels as Figures 14 and 15, but at an applied drain voltage of 2300 volts. The peak field still falls at the corner of the oxide (x = 3 and y = 1.2 microns), and the field strength at that point is 1.15 X 10⁶ V/cm; *i.e.,* still only a fraction of the field strength experienced by conventional devices at much lower voltages.

Figure 17 corresponds to Figure 16, but is taken along the vertical line of x = 3.0967 microns. As in the other plots taken along a vertical line, Figure 17 shows two peaks, the higher of which represents the p-n junction (x = 3.1 and y = 1.8 microns). At the p-n junction the electric field reaches approximately 3.1 x 10⁶ V/cm; *i.e.,* closer to the breakdown voltage of the silicon carbide at this doping level. The peak field strength in the oxide, however, remains much lower, on the order of about 1.47 X 10⁶ V/cm; *i.e.,* a fraction of the field strength that would become problematic.

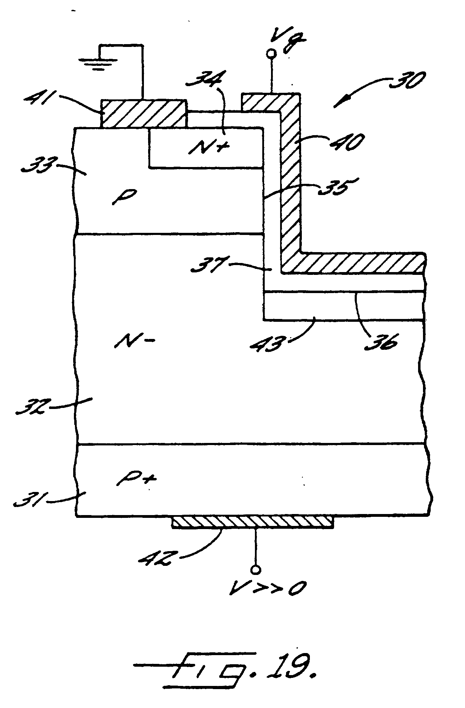

Finally, Figure 18 corresponds to Figure 13 (i.e., a vertical line at x = 1.0536 microns), except at the lower doping level (2.5E15 cm⁻¹) and the higher drain voltage (2300 volts). Figure 18 demonstrates that along this vertical line, the field is strong throughout the p and n portions of the device and is closer to breakdown at all such points (*i.e.,* always above about 2.10 X 10⁶ V/cm).

In short summary, Figures 4 through 18 demonstrate that the UMOS offers superior resistance to oxide degradation or breakdown at voltages that are both multiples and orders of magnitude higher than those at which conventional silicon carbide UMOS devices would experience breakdown. As a proviso, the relatively close proximity of the p-type epitaxial layer of the transistor to the implanted p-type protective region can encourage a pinching effect that may reduce the on-current of the device. Accordingly, the grounded p-type region is spaced sufficiently from the p-type epitaxial layer to minimize any such pinching effects.

A method of making the insulated gate silicon carbide power transistors comprises etching a first-opposite-first conductivity-type silicon carbide structure to define a trench with a first-opposite-first conductivity-type wall, forming an opposite conductivity type layer at the bottom of the trench and aligned by the trench walls, forming the appropriate oxidation layer on the trench walls and trench bottom, and then adding respective ohmic contacts to form the source, gate, and drain (or emitter in an IGBT).

Accordingly, in producing the previously described examples with the n-type source and drain, the method can further comprise growing a p-type epilayer on either an n-type epilayer or n-type substrate, followed by the step of forming an n-type well in the p-type epilayer. This produces an n-p-n SiC structure that can be etched to produce an n-p-n wall. Epitaxy of SiC is normally accomplished by chemical vapor deposition (CVD). Both 4H and 6H-SiC wafers with customer specified epilayers are commercially available. These layers can be nitrogen doped (n-type) or aluminum doped (p-type) at doping levels from 10¹⁴ cm⁻³ to 10²⁰ cm⁻³.

Selective-area doping is accomplished by ion implantation. This is necessary because thermal diffusion coefficients in SiC are too small for diffusion of impurities to be practical. SiC can be implanted to greater than 10¹⁹ cm⁻³ with nitrogen (n-type) and with either boron or aluminum (p-type). In preferred embodiments, the implantation is conducted with the wafer at an elevated temperature, and the implants are activated at 1200 to 1500°C in argon. (Note that at 1500°C, a silicon wafer would melt). Such high temperature implantation is described in U.S. Patent No. 5,087,576. Anisotropic etching is by RIE. Any fluorinated gas can be used, including NF₃ and SF₆. Appropriate techniques for etching silicon carbide are set forth for example in U.S. Patents Nos. 4,865,685 and 4,981,551. An early problem reported by several investigators was micromasking caused by aluminum particle contamination during RIE of SiC. This problem can be eliminated by adding a graphite cover plate over the aluminum cathode in the RIE chamber. Highly anisotropic profiles in 6H-SiC to a depth of tens of microns can accordingly be obtained. The surface morphology of the etched surfaces is good.

With respect to thermal oxidation, MOS oxides are critical elements of most semiconductor devices, particularly power devices. The important figures of merit are the interface state density DIT, the fixed charge density QF, and the breakdown field EBOX. A difficulty exists in obtaining an accurate measurement of the interface state density DIT on SiC. Because of the wide bandgap of SiC, deeper-lying interface states at the SiO₂/SiC interface are not in thermal equilibrium with the semiconductor at room temperature, and the occupancy of interface states cannot follow changes in the DC bias. To correctly measure the interface state density using CV techniques, it is necessary to heat the sample enough that the states can remain in quasi-steady-state as the gate voltage is changed. This has not been recognized by all SiC researchers, and several erroneous reports are present in the literature.

A better approach appears to be a modified hi-lo capacitance technique and an AC conductance technique at elevated temperatures to characterize the SiO₂/SiC interface. Thick oxides are used for field and intermediate dielectrics and as passivation layers for field termination on high-voltage devices. It is not practical to grow thick oxides by conventional thermal oxidation due to the long times and temperatures involved. Moreover, dopant redistribution (segregation) into a growing thermal oxide can be a problem. Several other techniques are preferred, depending on the circumstances: (i) deposition of thick SiO₂ by either LPCVD or PECVD, (ii) deposition of an amorphous silicon layer which is later converted to SiO₂ by thermal oxidation, or (iii) application of spin-on-glass (SOG).

Ohmic contacts are formed to n- and p-type layers by annealed nickel and annealed aluminum, respectively. These procedures are quite routine, and specific contact resistivities in the 10⁻⁶ ohm-cm² range can be obtained to heavily-doped n-type SiC. Ohmic contacts to p-type material are more difficult, and contact resistivities range from 10⁶ ohm-cm² for lightly-doped material to 10⁻¹ ohm-cm² for heavily doped material.

Schottky contacts are easy to fabricate, and Fermi level pinning is not observed. As a result, barrier heights are a function of the metal, and a wide range of barrier heights are attainable. Typical metals used for Schottky contacts on SiC are Au, Pt, and Ti.

Metal and polysilicon deposition procedures are similar to silicon, and no unusual problems are generally encountered. Preferred techniques include boat-evaporated aluminum, molybdenum or LPCVD polysilicon as gate materials for SiC MOSFETs.

In another embodiment, the invention comprises an insulated gate bipolar transistor (IGBT). As known to those familiar with such devices, an IGBT has the high input impedance and high speed characteristics of a MOSFET with the conductivity characteristic-low saturation voltage-of a bipolar transistor. In its most typical application, the IGBT is turned on by applying a positive voltage between the source and the emitter, and as in a MOSFET is turned off by making the gate signal zero or slightly negative. An IGBT has a much lower on resistance than a corresponding MOSFET. Compared to a MOSFET, an IGBT is generally smaller with the same current rating, although the bipolar action in an IGBT slows down the device so that it exhibits a much lower frequency than a corresponding MOSFET. IGBTs are discussed in some detail in Dorf, The Electrical Engineering Handbook (1993); CRC Press at pages 699-700; and related devices such as the field/controlled thyristor are discussed in Sze, Physics of Semiconductor Devices, Second Edition, 1981 at pages 238-240. Accordingly, the structure and function of the IGBT will not be discussed in detail herein other than to illustrate this embodiment of the present invention.

In this embodiment, the invention comprises an insulated gate bipolar power transistor formed in silicon carbide with silicon dioxide as the gate insulator. The transistor includes a source with the first conductivity type, and a protective region beneath the gate oxide that has the opposite conductivity type from the source, for protecting the gate oxide from the degrading or breakdown effects of a large voltage applied across the transistor.

An IGBT according to the present invention is illustrated in Figure 19 and is broadly designated at 30. The IGBT 30 comprises a p-type silicon carbide substrate 31, an n-type silicon carbide epitaxial layer 32 on the p-type substrate 31, a p-type silicon carbide epitaxial layer 33 on the n-type epitaxial layer 32, and an n-type well 34 in the p-type epitaxial layer 33. A gate trench illustrated by its wall 35 and bottom 36 extend through the n-type well 34 and the p-type epitaxial layer 33 and terminates in the n-type substrate 32. A gate oxide 37 is on the wall 35 and bottom 36 of the trench. Respective ohmic contacts 40, 41, and 42 to the gate oxide 37 to the n-type well 34 and to p-type substrate 31 define the gate, the source, and the emitter.

As in the other embodiments, the IGBT 30 includes a p-type silicon carbide region 43 between the gate oxide 37 and the n-type epitaxial layer 32 and aligned with the bottom 36 of the gate trench for protecting the oxide 37 in the trench from the degrading or breakdown effects of a large positive voltage applied across the transistor 30. The p-type region is grounded and is formed by implantation as discussed previously. Similarly, and as in the MOSFET examples, the p-type region 43 is spaced sufficiently from the p-type epitaxial layer 33 to minimize any current pinching effects between the p-type region 43 and the p-type epitaxial layer 33.

As in the examples, the ohmic contacts to the n-type regions are selected from the group consisting of nickel and nickel alloys, while the ohmic contacts to the p type material are preferably selected from the group consisting of aluminum, aluminum alloys, and cobalt silicide. As in the examples nitrogen is typically preferred for doping the n-type material, while the p-type material is typically doped with either aluminum or boron. As in the earlier embodiments, the silicon carbide in the transistor 30 has a polytype selected from the group consisting of 4H and 6H.

### Reducing the On-Resistance

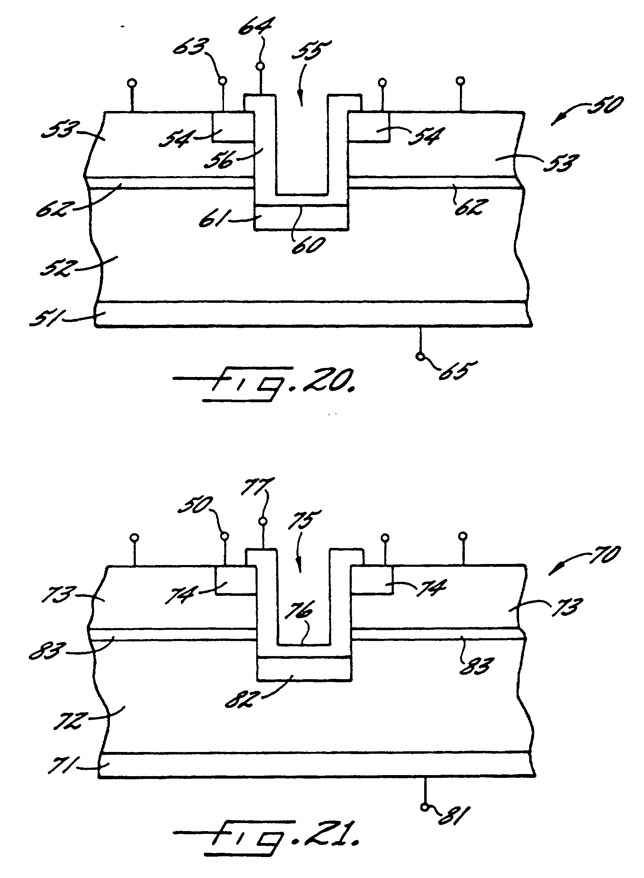

Figure 20 illustrates an embodiment according to the invention. In this regard, the MEDICI™ simulation used herein also indicates that the protection offered by the additional p-type layer at the bottom of the trench increases as the distance ("d" in Figure 20) along the trench wall between the p-type layer of the transistor and the p-type protection layer decreases. Stated in the alternative, the protective effect on the oxide is better when these two p-type portions of the device are closer to one another. As a proviso noted in the above, however, decreasing this distance between the two p-type regions tends to encourage pinch-off between them which can eventually block all current at forward bias. Basic calculations indicate that for typically useful doping concentrations in the p and n-type portions of the UMOS (e.g., p = 2 X 10¹⁷ cm⁻³, n = 2.5 X 10¹⁵ cm⁻³), pinch off will occur when the distance between the two p-type portions is less than about 1.5 microns.

Obtaining a 1.5 micron gap, however, presents some problems. First, from a processing standpoint, physically defining such a distance requires that the trench be etched to a depth of about 3 microns. Accordingly, if aluminum is used in typical fashion as a reactive ion etching (RIE) mask, at least about 6750 A of aluminum will be theoretically required. In reality, however, because of the thickness variation of aluminum deposition and etch rate variation during RIE, 8,000 A of aluminum would be typically necessary for a safe mask. The aluminum mask then would need to be removed using lift off technology in order to keep straight sidewalls in the trench. Lifting off an 8,000 A layer of aluminum is technically difficult, however, and is best avoided if at all possible.

Alternatively, if the two p-type layers are spaced 1.5 microns or more apart to minimize the processing problems, the greater distance will correspondingly minimize the protective effect for which the additional p-type layer is included in the structure. Accordingly, there exists a need to tailor the geometry of the structures disclosed herein to minimize the possibility of pinching off the current and to avoid technical difficulties in masking and etching deep trenches solely for the purpose of establishing a minimum distance between the p-type layers.

Accordingly, in the embodiment illustrated in Figure 20, the present invention provides an insulated gate structure that minimizes the possibility of pinching off the current while at the same time taking advantage of the full capabilities of UMOS and IGBT structures, particularly in silicon carbide. In this embodiment, the invention comprises a UMOS field-effect transistor, including a trench and a trench oxide on the walls and bottom of the trench. A protective region is beneath the bottom portion of the trench oxide of the transistor for protecting the trench oxide from the degrading or breakdown effects of a large voltage applied across the device. A current enhancing layer is between the protective region and the channel of the insulated gate structure, and the current enhancing layer is preferably more heavily doped than the remainder of the n-type drain region of the transistor.

Figure 20 illustrates the present invention in the form of an upright metal oxide semiconductor p-channel enhancement type field effect transistor broadly designated at 50. The structure is designed to particularly take advantage of the properties of silicon carbide.

Figure 20 illustrates that the UMOS 50 of the invention includes an n-type silicon carbide substrate 51 with an n-type silicon carbide epitaxial layer 52 on the n-type substrate. As Figure 20 illustrates with the n+ and n- designations, in preferred embodiments the substrate 51 that meets the drain contact is more heavily doped than the epitaxial layer 52, to enhance the current flow to the drain. It will be understood that under some circumstances, a single substrate can take the place of the substrate 51 and the epilayer 52. The n+/n- structure, however, offers certain current-flow advantages, and is thus generally preferred.

A p-type epitaxial layer 53 forms the channel region of the UMOS 50 and an n-type well 54 forms the source. Figure 20 also illustrates the trench 55 and the gate oxide 56 that covers the walls 57 and bottom 60 of the trench 55. As in the previous embodiments, the invention includes the grounded p-type region 61 between the oxide 56 and the n-type epitaxial layer 52 and that is aligned with the bottom 60 of the gate trench 55 for protecting the oxide 56 in the trench 55 from the degrading or breakdown affects of a large positive voltage applied to the drain.

The UMOS of this embodiment, however, further comprises the current enhancing n-type layer 62, preferably an n+-type layer, between the grounded p-type region 61 and the p-type channel region 53 of the UMOS structure 50. The current enhancing n-type layer 62 is more heavily doped than the remainder of the n-type epitaxial layer 52. Figure 20 also illustrates the source contacts 63, the gate contact 64 and the drain contact 65.

By placing the current enhancing n-type layer 62 underneath the p-type channel layer 53, the structure avoids current pinch off even at much smaller distances (d) between the p-type channel portion 53 and the grounded p-type region 61. For example, the same calculations that demonstrate pinch off occurring at distances (d) of 1.5 microns or less in a structure such as Figure 1 demonstrate that pinch off can be avoided using the invention for distances (d) of as little as 0.18 microns. Accordingly, if the distance d can be made somewhat smaller, the processing of the structure can be made correspondingly easier while at the same time strengthening the protective effect of the p-type layer 61.

Additionally, the current enhancing layer 62 also helps to reduce the drain resistance at forward bias. In the absence of the additional n-type layer 62, the current spreading out from the bottom of the trench comer to the drain creates a large spreading resistance around the trench comer. By adding the n-type layer 62, the current can first flow laterally inside the n-type layer, and then flow down to the drain, thus minimizing or eliminating the spreading resistance under forward bias.

The MEDICI™ simulation program was again used to check the behavior of the structure of the present invention. The simulation demonstrated that at a concentration of about 2 X 10¹⁷ cm⁻³ in the n-type current enhancing layer 62, and a distance d of 0.18 microns between the two p-type portions 53 and 61, no pinch off occurs and forward current increases by a factor of about 10. It will be understood that the doping concentration and the thickness of the n-type layer 62 should be designed carefully so that the n-type layer 62 can effectively strengthen the protective effect of the grounded p-type layer 61 while at the same time still providing the maximum usage of the n- region 52 to block reverse voltage drop.

In summary, the addition of the n-type layer 62 serves at least two purposes. First, it prevents pinch off even for a very small d thus in turn strengthening the protective effect of the grounded p-type layer 61 at reverse bias. Second, the n-type layer 62 reduces the on-resistance at forward bias. As noted above, preliminary two-dimensional MEDICI™ simulation appears to verify these two advantages.

From a processing standpoint, the addition of the n-type layer 62 is relatively straightforward in that it requires simply growing one more epitaxial layer while using the identical mask design and processes that are used to make the UMOS illustrated in Figure 2.

As some additional details, in preferred embodiments, the n-type substrate 51 typically has a carrier concentration of about 2 X 10¹⁹ cm⁻³. The n-type epitaxial layer 52 generally has a carrier concentration of between about 2.5 X 10¹⁵ cm⁻¹ and 2 X 10¹⁶ cm⁻³. The current enhancing n-type epitaxial layer 62 preferably has a carrier concentration about 2 X 10¹⁷ cm⁻³. The p-type epitaxial layers 53 and the grounded p-type region 61 typically have carrier concentrations of between 2 X 10¹⁷ cm⁻³ and 5 X 10¹⁷ cm⁻³. As discussed with regard to the earlier embodiments, when the semiconductor is silicon carbide, the grounded p-type region 61 is typically an implanted region doped with aluminum or boron. Additionally, in the silicon carbide embodiments, the preferred n-type dopant is nitrogen and the preferred dopant for the p-type epilayer 53 is also aluminum. When the structure is formed in silicon, the preferred p-type dopant is boron, and the preferred n-type dopants are phosphorous, arsenic, and antimony.

In the silicon carbide embodiments, the ohmic contacts 63 and 65 to the n-type well 54 and n-type substrate 51 are generally selected from the group consisting of nickel and nickel alloys, while the p-type region 61 is grounded through an ohmic contact (not shown) selected from the group consisting of aluminum and aluminum alloys and cobalt silicide (CoSi₂).

In another aspect, the present embodiment can be described by the structure of the trench 55. This structure comprises the trench wall 57 and the grounded p-type region 61 that forms the trench bottom 60. The trench wall 57 and trench bottom 60 are covered by the gate oxide 56 of the UMOS 50. The trench wall 57 beneath the oxide 56 in turn comprises the n+ well 54 for the source, the p-type epitaxial layer 53 for the channel positioned beneath the n+ type well 54, the current enhancing n-type type layer 62 beneath the p-type epitaxial layer 53, and the n-type drain region 52 (together with the substrate 51) beneath the current enhancing n-type layer 62. As in the other embodiments, the n-type drain region 52 is less heavily doped than the current enhancing n-type layer 62.

In another embodiment, the invention comprises an insulated gate bipolar transistor (IGBT) formed in silicon carbide with silicon dioxide as the gate insulator. The transistor has a source with a first conductivity type, a protective region adjacent the gate oxide and that has the opposite conductivity type from the source for protecting the gate oxide from the degrading or breakdown effects of a large voltage applied across the transistor, and a current enhancing layer having the first conductivity type and positioned between the protective region and the source region of the transistor.

Figure 21 illustrates a particularly preferred IGBT embodiment broadly designated at 70. The IGBT 70 comprises a p-type silicon carbide substrate 71, an n-type silicon carbide epitaxial layer 72 on the p-type substrate 71, a p-type silicon carbide epitaxial layer 73 on the n-type epitaxial layer 72, an n-type well 74 in the p-type epitaxial layer 73, and a gate trench broadly designated at 75 extending through the n-type well 74, the p-type epitaxial layer 73, and terminating in the n-type epitaxial layer 72. A gate oxide 76 is on the walls and bottom of the trench 75 and respective ohmic contacts 77, 80, and 81 are made to the gate oxide 76, to the n-type well 74 and to the p-type substrate 71 for respectively defining the gate, the source, and the emitter.

A p-type silicon carbide protective region 82 is between the oxide 76 and the n-type epitaxial layer 72 and is aligned with the bottom of the gate trench 75 for protecting the oxide 76 in the trench 75 from the degrading or breakdown effects of a large, positive voltage applied across the IGBT 70. An n-type current enhancing layer 83 is positioned between the protective region 82 and the source 74.

As in previous examples, the p-type protective region 82 is grounded with an ohmic contact selected from the group consisting of aluminum, aluminum alloys, and cobalt silicide and is preferably formed by ion implantation. The ohmic contacts to the n-type well 74 are preferably selected from the group consisting of nickel and nickel alloys. The n-type well 74, n-type epitaxial layer 72 and n-type current enhancing layer 83 are all preferably doped with nitrogen, and the preferred dopant for the p-type epitaxial layer 73 is selected from the group consisting of aluminum and boron. As in the other examples, the silicon carbide preferably has a polytype selected from the group consisting of 4H and 6H.

## Claims

1. A UMOS power transistor which demonstrates increased maximum voltage and which is a metal oxide semiconductor, enhancement-type field effect transistor (50) comprising a trench and a trench oxide (56) on the walls and bottom of said trench, a source (54) and drain (52) with a first conductivity type, a channel. region (53) with the opposite conductivity type, a region (61) beneath said trench oxide that has the opposite conductivity type from said source (54) and drain (52) for protecting said trench oxide from the degrading or breakdown effects of a large voltage applied to the drain and is spaced sufficiently from said channel region (53) to minimize any current pinching effects between said region (61) and said channel region, and a current enhancing layer (62) of first conductivity type which is more heavily doped than said drain region (52), wherein the transistor is formed in SiC, wherein said region (61) is electrically connected to a ground terminal formed on the transistor and wherein the current enhancing layer (62) extends laterally below said channel region (53) and above said drain region (52).

2. A transistor according to Claim 1, wherein said source (54) and drain (52) are p-type and said region (61) beneath said trench oxide (56) is n-type.

3. A transistor according to Claim 1 comprising an n-type silicon carbide substrate (51), a p-type silicon carbide epitaxial layer (53) on said n-type substrate, an n-type well (54) in said p-type epitaxial layer, wherein said trench is a gate trench extending through said n-type well and said p-type epitaxial layer and terminating in said n-type substrate and said trench oxide (56) is a gate oxide (17, 56) on the walls and bottom of said trench, and respective ohmic contacts (64, 63, 65) to said gate oxide for defining a gate, to said n-type well for defining a source, and to said substrate for defining a drain, and wherein said region (61) beneath said trench is a p-type silicon carbide region between said oxide (56) and said n-type substrate (51) and aligned with the bottom of said gate trench.

4. A transistor according to claim 3, wherein said n-type substrate (51) has a carrier concentration of about 2 X 10¹⁶ cm⁻³; and said p-type epitaxial layer has a carrier concentration of about 5 X 10¹⁷ cm⁻³.

5. A transistor according to claim 3 or 4, including an n-type epitaxial layer (52) in contact with said n-type substrate (51) and between said n-type substrate and said p-type epitaxial layer (53).

6. A transistor according to claim 5, wherein said n-type substrate (51) is more heavily doped than said n-type epitaxial layer (52).

7. A transistor according to claim 5, wherein said n-type substrate (51) has a carrier concentration of about 2 X 10¹⁹ cm⁻³ and said n-type epitaxial layer (52) has a carrier concentration of between about 2.5 X 10¹⁵ cm⁻³ and 2 X 10¹⁶ cm⁻³.

8. A transistor according to any of the preceding claims, 5, 6 or 7, wherein said n-type epitaxial layer (52) is doped with nitrogen.

9. A transistor according to any one of the preceding claims 5 to 8, wherein said p-type epitaxial layer (53) has a carrier concentration of about 5 X 10¹⁷ cm⁻³; and said p-type region (61) has a carrier concentration of about 5 X 10¹⁷ cm⁻³ .

10. An insulated gate bipolar power transistor (IGBT) which demonstrates increased maximum voltage and which is a transistor comprising a p-type substrate (71), an n-type epitaxial layer (72) on said p-type substrate (71), a p-type epitaxial layer (73) above said n-type epitaxial layer, an n-type well (74) in said p-type epitaxial layer (73), a gate trench extending through said n-type well (74) and said p-type epitaxial layer (73) and terminating in said n-type epitaxial layer, a gate insulating material (76) on the walls and bottom of said trench, respective ohmic contacts (50, 77, 81) to said gate insulating material for defining a gate, to said n-type well for defining a source, and to said substrate for defining an emitter, a p-type region (82) between said insulating material and said n-type epitaxial layer (72), said p-type region being aligned with the bottom of said gate trench for protecting said insulating material in said trench from the degrading or breakdown effects of a large positive voltage applied across said transistor and spaced sufficiently from said p-type epitaxial layer (73) to minimize any current pinching effects between said p-type region and said p-type epitaxial layer, and an n-type current enhancing layer (83) which is more heavily doped than said n-type epitaxial layer (72), wherein said p-type region (82), substrate (71), epitaxial layers (72, 73) and n-type well (74) are silicon carbide, wherein said p-type region (82) is electrically connected to a ground terminal formed on the transistor, and wherein the current enhancing layer (83) extends laterally below said p-type epitaxial layer (73) and above said n-type epitaxial layer (72), and said gate trench extends through said current enhancing layer.

11. A transistor according to any one of the preceding claims 3 to 10, wherein said ohmic contacts to said n-type well (54, 74) and said n-type substrate (51) are selected from the group consisting of nickel and nickel alloys.

12. A transistor according to any one of the preceding claims 3 to 11, wherein the dopant for said p-type epitaxial layer (53, 73) is selected from the group consisting of aluminum and boron.

13. A transistor according to any one of the preceding claims 3 to 12, wherein said n-type well (54, 74) and said n-type substrate are both doped with nitrogen.

14. A transistor according to any one of the preceding claims, wherein said p-type region (61, 82) is grounded through an ohmic contact selected from the group consisting of aluminum, aluminum alloys, and cobalt silicide.

15. A transistor according to any one of the preceding claims, wherein the dopant for said p-type region (61) is selected from the group consisting of aluminum and boron.

16. A transistor according to any one of the preceding claims, wherein said p-type region (61, 82) is an implanted region.

17. A transistor according to any one of the preceding claims, wherein the silicon carbide has a polytype selected from the group consisting of 4H and 6H.

18. A transistor according to claim 10, wherein the n-type current enhancing layer (83) is positioned between said p-type region (82) and the source region (54) of said transistor.

19. A transistor according to any one of the preceding claims, wherein the oxide or insulating material (56, 76) comprises silicon dioxide.

## Patentansprüche

1. UMOS-Leistungstransistor, der eine erhöhte Maximalspannung zeigt und der ein Metalloxidhalbleiter-Feldeffekttransistor (50) vom Anreicherungstyp ist, der einen Graben und ein Grabenoxid (56) an den Wänden und dem Boden des Grabens, eine Source (54) und eine Drain (52) eines ersten Leitfähigkeitstyps, einen Kanalbereich (53) des entgegengesetzten Leitfähigkeitstyps, einen Bereich (61) unterhalb des Grabenoxids, der den zu der Source (54) und der Drain (52) entgegengesetzten Leitfähigkeitstyp aufweist, um das Grabenoxid gegen Abbau- oder Zusammenbrucheffekte einer großen Spannung zu schützen, die an die Drain angelegt ist, und der ausreichend von dem Kanalbereich (53) beabstandet ist, um jegliche Stromeinschnürungseffekte zwischen dem Bereich (61) und dem Kanalbereich zu minimieren, und eine Stromanreicherungsschicht (62) des ersten Leitfähigkeitstyps aufweist, die stärker dotiert ist als der Drainbereich (52), wobei der Transistor in SiC gebildet ist, wobei der Bereich (61) elektrisch mit einem Erdungsanschluss verbunden ist, der an dem Transistor gebildet ist, und wobei sich die Stromanreicherungsschicht (62) seitlich unter dem Kanalbereich (53) und über dem Drainbereich (52) erstreckt.

2. Transistor nach Anspruch 1, wobei die Source (54) und die Drain (52) p-leitend und der Bereich (61) unterhalb des Grabenoxids (56) n-leitend ist.

3. Transistor nach Anspruch 1, der ein n-leitendes Siliciumkarbidsubstrat (51), eine p-leitende Siliciumkarbid-Epitaxialschicht (53) auf dem n-leitenden Substrat, eine n-leitende Mulde (54) in der p-leitenden Epitaxialschicht, wobei der Graben ein Gategraben ist, der sich durch die n-leitende Mulde und die p-leitende Epitaxialschicht erstreckt und in dem n-leitenden Substrat endet, und wobei das Grabenoxid (56) ein Gateoxid (17, 56) an den Wänden und dem Boden des Grabens ist, und jeweilige ohmsche Kontakte (64, 63, 65) aufweist, und zwar zu dem Gateoxid zum Definieren eines Gates, zu der n-leitenden Mulde zum Definieren einer Source, und zu dem Substrat zum Definieren einer Drain, und wobei der Bereich (61) unterhalb des Grabens ein p-leitender Siliciumkarbidbereich zwischen dem Oxid (56) und dem n-leitenden Substrat (51) ist und nach dem Boden des Gategrabens ausgerichtet ist.

4. Transistor nach Anspruch 3, wobei das n-leitende Substrat (51) eine Trägerkonzentration von ungefähr 2 x 10¹⁶ cm⁻³ aufweist, und wobei die p-leitende Epitaxialschicht eine Trägerkonzentration von ungefähr 5 x 10¹⁷ cm⁻³ aufweist.

5. Transistor nach Anspruch 3 oder 4, der eine n-leitende Epitaxialschicht (52) umfasst, die in Berührung mit dem n-leitenden Substrat (51) steht und zwischen dem n-leitenden Substrat und der p-leitenden Epitaxialschicht (53) angeordnet ist.

6. Transistor nach Anspruch 5, wobei das n-leitende Substrat (51) stärker dotiert ist als die n-leitende Epitaxialschicht (52).

7. Transistor nach Anspruch 5, wobei das n-leitende Substrat (51) eine Trägerkonzentration von ungefähr 2 x 10¹⁹ cm⁻³ aufweist und die n-leitende Epitaxialschicht (52) eine Trägerkonzentration von zwischen ungefähr 2,5 x 10¹⁵ cm⁻³ und 2 x 10¹⁶ cm⁻³ aufweist.

8. Transistor nach einem der vorhergehenden Ansprüche 5, 6 oder 7, wobei die n-leitende Epitaxialschicht (52) mit Stickstoff dotiert ist.

9. Transistor nach einem der vorhergehenden Ansprüche 5 bis 8, wobei die p-leitende Epitaxialschicht (53) eine Trägerkonzentration von ungefähr 5 x 10¹⁷ cm⁻³ aufweist, und wobei der p-leitende Bereich (61) eine Trägerkonzentration von ungefähr 5 x 10¹⁷ cm⁻³ aufweist.

10. Bipolarleistungstransistor (IGBT) mit isoliertem Gate, der eine erhöhte Maximalspannung zeigt und der einen Transistor darstellt, der ein p-leitendes Substrat (71), eine n-leitende Epitaxialschicht (72) auf dem p-leitenden Substrat (71), eine p-leitende Epitaxialschicht (73) über der n-leitenden Epitaxialschicht, eine n-leitende Mulde (74) in der p-leitenden Epitaxialschicht (73), einen Gategraben, der sich durch die n-leitende Mulde (74) und die p-leitende Epitaxialschicht (73) erstreckt und in der n-leitenden Epitaxialschicht endet, ein Gate-isolierendes Material (76) an den Wänden und dem Boden des Grabens, jeweilige ohmsche Kontakte (50, 77, 81) zu dem Gate-isolierenden Material zum Definieren eines Gates, zu der n-leitenden Mulde zum Definieren einer Source, und zu dem Substrat zum Definieren eines Emitters, einen p-leitenden Bereich (82) zwischen dem isolierenden Material und der n-leitenden Epitaxialschicht (72), wobei der p-leitende Bereich nach dem Boden des Gategrabens ausgerichtet ist, um das isolierende Material in dem Graben gegen die Abbau- oder Zusammenbruchseffekte einer großen positiven Spannung zu schützen, die über dem Transistor angelegt ist, und der ausreichend von der p-leitenden Epitaxialschicht (73) beabstandet ist, um jegliche Stromeinschnürungseffekte zwischen dem p-leitenden Bereich und der p-leitenden Epitaxialschicht zu minimieren, und eine n-leitende Stromanreicherungsschicht (83) aufweist, die stärker dotiert ist als die n-leitende Epitaxialschicht (72), wobei der p-leitende Bereich (82), das Substrat (71), die Epitaxialschichten (72, 73) und die n-leitende Mulde (74) aus Siliciumkarbid sind, wobei der p-leitende Bereich (82) elektrisch mit einem Erdungsanschluss verbunden ist, der an dem Transistor gebildet ist, und wobei sich die Stromanreicherungsschicht (83) seitlich unter der p-leitenden Epitaxialschicht (71) und über der n-leitenden Epitaxialschicht (72) erstreckt, und wobei der Gategraben sich durch die Stromanreicherungsschicht erstreckt.

11. Transistor nach einem der vorhergehenden Ansprüche 3 bis 10, wobei die ohmschen Kontakte zu der n-leitenden Mulde (54, 74) und das n-leitende Substrat (51) aus der Gruppe ausgewählt sind, die aus Nickel und Nickellegierungen besteht.

12. Transistor nach einem der vorhergehenden Ansprüche 3 bis 11, wobei das Dotierungsmaterial für die p-leitende Epitaxialschicht (53, 73) aus der Gruppe ausgewählt ist, die aus Aluminium und Bor besteht.

13. Transistor nach einem der vorhergehenden Ansprüche 3 bis 12, wobei sowohl die n-leitende Mulde (54, 74) als auch das n-leitende Substrat mit Stickstoff dotiert sind.

14. Transistor nach einem der vorhergehenden Ansprüche, wobei der p-leitende Bereich (61, 82) durch einen ohmschen Kontakt geerdet ist, der aus der Gruppe ausgewählt ist, die aus Aluminium, Aluminiumlegierungen und einer Kobalt-Siliciumverbindung besteht.

15. Transistor nach einem der vorhergehenden Ansprüche, wobei das Dotierungsmaterial für den p-leitenden Bereich (61) ausgewählt aus der Gruppe ist, die aus Aluminium und Bor besteht.

16. Transistor nach einem der vorhergehenden Ansprüche, wobei der p-leitende Bereich (61, 82) ein implantierter Bereich ist.

17. Transistor nach einem der vorhergehenden Ansprüche, wobei das Siliciumkarbid einen Polytyp aufweist, der aus der Gruppe ausgewählt ist, die aus 4H und 6H besteht.

18. Transistor nach Anspruch 10, wobei die n-leitende Stromanreicherungsschicht (83) zwischen dem p-leitenden Bereich (82) und dem Sourcebereich (54) des Transistors angeordnet ist.

19. Transistor nach einem der vorhergehenden Ansprüche, wobei das Oxid oder das isolierende Material (56, 76) Siliciumdioxid aufweist.

## Revendications

1. Transistor de puissance à tranchées qui affiche une tension maximale accrue et qui est un semiconducteur métal oxyde, un transistor à effet de champ de type modifié (60) comprenant une tranchée et un oxyde de tranchée (56) sur les parois et le fond de la tranchée, une source (64) et un drain (52) d'un premier type de conductivité, une région de canal (53) de type de conductivité opposée, une région (61) en dessous du dit oxyde de tranchée qui présente le type de conductivité opposée à celle de ladite source (54) et le drain (52) pour protéger ledit oxyde de tranchée des effets de dégradation et de claquage d'une tension importante appliquée sur le drain et est suffisamment espacé de ladite région de canal (53) pour minimiser tous les effets de pincement du courant entre ladite région (61) et ladite région de canal et une couche d'amplification de courant (62) du premier type de conductivité qui est plus fortement dopée que ladite région de drain (52), dans lequel le transistor est constitué de carbure de silicium (SIC), dans lequel ladite région (61) est reliée électriquement à une borne de terre constituée sur le transistor et dans lequel la couche d'amplification de courant (62) s'étend latéralement en dessous de ladite région de canal (53) et au-dessus de ladite région de drain (52).

2. Transistor selon la revendication 1, dans lequel ladite source (54) et le drain (52) sont de type p et ladite région (61) en dessous dudit oxyde de tranchée (56) est de type n.

3. Transistor selon la revendication 1, comprenant un substrat de carbure de silicium de type n (51), une couche épitaxiale de carbure de silicium (53) de type p sur ledit substrat de type n, un puits de type n (54) dans ladite couche épitaxiale de type p, dans lequel ladite tranchée est une tranchée de grille s'étendant au travers dudit puits de type n et de ladite couche épitaxiale de type p et se termine dans ledit substrat de type n et ledit oxyde de tranchée (56) est un oxyde de grille (17-56) sur les parois et le fond de ladite tranchée et les contacts ohmiques respectifs (64, 63, 65) audit oxyde de grille pour définir une grille, audit puits de type n pour définir une source et audit substrat pour définir un drain, et dans lequel ladite région (61) en dessous de ladite tranchée est une région de carbure de silicium de type p entre ledit oxyde (56) et ledit substrat de type n (51) et alignée sur le fond de ladite tranchée de grille.

4. Transistor selon la revendication 3, dans lequel ledit substrat de type n (51) présente une concentration de porteur d'environ 2 x 10¹⁵ cm⁻³ et ladite couche épitaxiale de type p présente une concentration de porteur d'environ 5 x 10¹⁷ cm⁻³.

5. Transistor selon la revendication 3 ou 4 comprenant une couche épitaxiale de type n (52) en contact avec ledit substrat de type n (51) et entre ledit substrat de type n et ladite couche épitaxiale de type p (53).

6. Transistor selon la revendication 5, dans lequel ledit substrat de type n (51) est plus fortement dopé que ladite couche épitaxiale de type n (52).

7. Transistor selon la revendication 5, dans lequel ledit substrat de type n (51) présente une concentration de porteur d'environ 2 x 10¹⁹ cm⁻³ et une couche épitaxiale de type n (52) présentant une concentration de porteur entre environ 2,5 x 10¹⁵ cm⁻³ et environ 2 x 10¹⁶ cm⁻³.

8. Transistor selon l'une quelconque des revendications 5, 6 ou 7 précédentes, dans lequel ladite couche épitaxiale de type n (52) est dopée avec de l'azote.

9. Transistor selon l'une quelconque des revendications 5 à 8 précédentes, dans lequel ladite couche épitaxiale de type p (53) présente une concentration de porteur d'environ 5 x 10¹⁷ cm⁻³ et ladite région de type p (61) présente une concentration de porteur d'environ 5 x 10¹⁷ cm⁻³.

10. Transistor de puissance bipolaire à grille isolée (IGBT) qui présente une tension maximale accrue et qui est un transistor comprenant un substrat de type p (71), une couche épitaxiale de type n (72) sur ledit substrat de type p (71), une couche épitaxiale de type p (73) au-dessus de ladite couche épitaxiale de type n, un puits de type n (74) dans ladite couche épitaxiale de type p (73), une tranchée de grille s'étendant au travers dudit puits de type n (74) et de ladite couche épitaxiale de type p (73) et se terminant dans ladite couche épitaxiale de type n, un matériau d'isolation de grille (76) sur les parois et le fond de ladite tranchée, des contacts ohmiques respectifs (50, 77, 81) audit matériau isolant de grille pour définir une grille, audit puits de type n pour définir une source et audit substrat pour définir un émetteur, une région de type p (82) entre ledit matériau isolant et ladite couche épitaxiale de type n (72), ladite région de type p étant alignée avec le fond de ladite trachée de grille pour protéger ledit matériau isolant dans ladite tranchée des effets de dégradation et de claquage d'une forte tension positive appliquée sur le transistor et suffisamment éloignée de ladite couche épitaxiale de type p (73) pour minimiser tous les effets de pincement du courant entre ladite région de type p et ladite couche épitaxiale de type p et une couche d'amplification de courant de type n (83) qui est plus fortement dopée que ladite couche épitaxiale de type n (72), dans lequel ladite région de type p (82), le substrat (71), les couches épitaxiales (72, 73) et le puits de type n (74) sont réalisés en carbure de silicium, dans lequel ladite région de type p (82) est reliée électriquement à une borne de terre formée sur le transistor, et dans lequel la couche amplificatrice de courant (83) s'étend latéralement en dessous de ladite couche épitaxiale de type p (70) et au-dessus de ladite couche épitaxiale de type n (72) et ladite tranchée de grille s'étend au travers de ladite couche amplificatrice de courant.

11. Transistor selon l'une quelconque des revendications 3 à 10 précédentes, dans lequel lesdits contacts ohmiques audit puits de type n (54, 74) et ledit substrat de type n (61) sont choisis dans le groupe constitué par le nickel et les alliages de nickel.

12. Transistor selon l'une quelconque des revendications 3 à 11 précédentes, dans lequel le dopant pour ladite couche épitaxiale de type p (53, 73) est choisi dans de groupe constitué par l'aluminium et le bore.

13. Transistor selon l'une quelconque des revendications 3 à 12, dans lequel le puits de type n (54, 74) et ledit substrat de type n sont tous deux dopés à l'azote.

14. Transistor selon l'une quelconque des revendications précédentes dans lequel ladite région de type p (61, 82) est mise à la terre par un contact ohmique choisi dans le groupe constitué par l'aluminium, les alliages d'aluminium et le siliciure de cobalt.

15. Transistor selon l'une quelconque des revendications précédentes, dans lequel le dopant pour ladite région de type p (61) est choisi dans le groupe constitué par l'aluminium et le bore.

16. Transistor selon l'une quelconque des revendications précédentes, dans lequel ladite région de type p (61) est une région implantée.

17. Transistor selon l'une quelconque des revendications précédentes, dans lequel le carbure de silicium présente un polytipisme choisi dans le groupe constitué par 4H et 8H.

18. Transistor selon la revendication 10, dans lequel la couche amplificatrice de courant de type n (83) est placée entre ladite région de type p (82) et la région de source (54) dudit transistor.

19. Transistor selon l'une quelconque des revendications précédentes, dans lequel l'oxyde ou le matériau isolant (56, 76) comprend du dioxyde de silicium.
